# EUROPEAN PATENT APPLICATION

(11) **EP 4 726 771 A1**
(43) Date of publication of application: **15.04.2026**
(21) Application number: 24206095.2
(22) Date of filing: 11.10.2024
(51) Int. Cl.: H01L 21/28, H10D 64/01, H10D 64/68, B82Y 10/00

(54) **A METHOD FOR FORMING A GATE STACK**

(71) Applicant: Imec VZW, 3001 Leuven (BE)
(72) Inventor: ARIMURA, Hiroaki, 3000 Leuven (BE); HORIGUCHI, Naoto, 3000 Leuven (BE)
(74) Representative: AWA Sweden AB

(57) **Abstract**

The present invention provides a method for forming a gate stack (100) on a semiconductor substrate (102), the method comprising:
forming a dielectric interlayer (103) on the semiconductor substrate (102),
forming a dipole-forming layer (104) comprising a work function shifting metal and oxygen on top of the dielectric interlayer (103);
etching the dipole-forming layer (104) such that a residue (106) of the dipole-forming layer (104) remains on the dielectric interlayer (103), the residue (106) being less than one monolayer of the dipole-forming layer (104), wherein a temperature is kept below 430 °C between said acts of forming the dipole-forming layer (104) and etching the dipole-forming layer (104);
depositing a gate dielectric (108); and
depositing a metal gate (110) on the gate dielectric (108).

## Description

### TECHNICAL FIELD

The present disclosure relates to a method for forming a gate stack.

### BACKGROUND

A gate stack for a semiconductor device, such as a field effect transistor (FET), may comprise a dielectric layer or more specifically a gate dielectric layer. The dielectric layer is a dielectric between the channel and the gate electrode/gate contact. The voltage at which the semiconductor device turns on, is called the threshold voltage (Vt). There are various ways to control Vt. One way to control Vt is to diffuse metal atoms into the dielectric layer to form interface dipoles and thereby control the effective work function.

One notable example of a FET is the nanosheet FET (NSFET). The NSFET comprises at least one channel, in the form of a nanosheet, extending horizontally between a source and a drain. The gate of the NSFET may extend around each channel to form a gate-all-around (GAA).

Another notable example of a FET is a stack of NSFETs comprising at least a first and a second NSFET, the second NSFET being stacked on top of the first NSFET. An example is the so-called complementary FET (CFET), wherein one NSFET of the stack of NSFETs is p-type and the other is n-type.

Another notable example of a FET is the forksheet FET. The forksheet FET comprises a pair of transistors being arranged side by side, in relatively close proximity, and separated by an insulating wall. Each of the pair of transistors comprise at least one channel, in the form of a nanosheet, extending horizontally between a source and a drain. Each transistor of the pair of transistors is controlled by a fork-shaped gate arranged at three sides of the channels.

### SUMMARY

It is an objective of the present inventive concept to provide a method for forming a high-quality gate stack for a semiconductor device. A further objective is to provide a gate stack enabling fine-tuning of EWF/Vt. A further objective is to provide a method for forming a gate stack with a low thermal budget. A further objective is to provide a method for forming a gate stack that enables further device scaling. Further and alternative objectives may be understood from the following.

According to a first aspect of the invention, there is provided a method for forming a gate stack on a semiconductor substrate, the method comprising:
forming a dielectric interlayer on the semiconductor substrate,
forming a dipole-forming layer comprising a work function shifting metal and oxygen on top of the dielectric interlayer;
etching the dipole-forming layer such that a residue of the dipole-forming layer remains on the dielectric interlayer, the residue being less than one monolayer of the dipole-forming layer, wherein a temperature is kept below 430 °C between said acts of forming the dipole-forming layer and etching the dipole-forming layer;
depositing a gate dielectric; and
depositing a metal gate on the gate dielectric.

The present method may be performed in conjunction with a replacement metal gate (RMG) process (or any other suitable gate formation process step).

Whenever there is a reference to a gate stack being formed on a semiconductor substrate, it should be noted that there may be arranged an intermediate layer between the gate stack and the substrate. Such an intermediate layer may be a channel layer. In other words, it may alternatively be said that the first aspect of the invention may provide a method for forming a gate stack on a channel layer, the method comprising forming a dielectric interlayer on the channel layer, forming a dipole-forming layer comprising a work function shifting metal and oxygen on top of the dielectric interlayer, etching the dipole-forming layer such that a residue of the dipole-forming layer remains on the dielectric interlayer, the residue being less than one monolayer of the dipole-forming layer, wherein a temperature is kept below 430 °C between said acts of forming the dipole-forming layer and etching the dipole-forming layer, depositing a gate dielectric and depositing a metal gate on the gate dielectric.

It is conceivable that the channel may be formed on top of or above the substrate. This is conventionally the case with non-planar FET devices such as NSFET devices. The channel may alternatively be formed as part of the substrate. In other words, the substrate may comprise the channel. This is conventionally the case with planar FET devices such as MOSFET devices. Hence, whenever there is a reference to the gate stack being formed on the substrate, this could be construed as the gate stack being formed on the channel of the substrate. The channel layer may be the channel between the source and drain (S/D) regions of the semiconductor device.

The semiconductor device may herein be a transistor, e.g., a (planar) MOSFET or a (non-planar) NSFET. Prior to forming the gate stack, the channel layer may be released. For example, the channel layer may be part of a layer stack comprising a sacrificial layer below the channel layer and a sacrificial layer above the channel layer. The channel layer may be released by removing the sacrificial layers. The gate stack may be formed around the channel layer, e.g. as a gate-all-around. Alternatively, the gate stack may be formed at three sides of the channel layer, e.g. as a tri-gate (e.g. for a forksheet FET).

The substrate may be a substrate (suitable) for a FET, e.g. a substrate for a NSFET, a substrate for a CFET, or a substrate for a forksheet FET. The substrate may comprise silicon. However, the method is applicable on any substrate. The present method may be applied, e.g. directly on a wafer.

The dielectric interlayer may comprise an oxide, e.g., silicon oxide and/or silicon oxynitride.

The work function shifting metal of the dipole-forming layer may comprise any one of aluminium (Al), titanium (Ti), germanium (Ge), and niobium (Nb). Thus, the dipole-forming layer may be an aluminum oxide (such as Al₂O₃), a titanium oxide, a germanium oxide, or a niobium oxide.

The first aspect of the invention is based on the insight that traditional schemes to control Vt, as conventionally used in conjunction with gate formation processing steps such as a RMG process, generally require a high thermal budget. Such schemes may entail the step of depositing metal atoms on top of the dielectric layer followed by a high-temperature (above 430 °C) anneal in order to diffuse the metal atoms into the dielectric layer. By doing this, an interface dipole region is formed on the surface of the dielectric layer. The interface dipole region is thus formed at the interface between the dielectric interlayer and the dipole-forming layer. Hence, the diffused metal atoms, acting as dipoles, in the interface dipole region may control the effective work function and thereby allow control of EWF/Vt.

In contrast, the present method is advantageous in that by virtue of the (atomically) thin residue, even finer adjustments of the EWF/Vt are enabled. An interface dipole region may be formed between the residue and the underlying dielectric interlayer. The interface dipole region may form a physical region.

The present method is further advantageous in that the step of forming the residue is devoid of a high-temperature (above 430°C, or more preferably above 500°C) drive-in anneal.

It is a realization that a high-temperature gate stack formation may damage other features of the transistor that is to be produced. For example, contacts (such as source/drain contacts) may be damaged by a high temperature processing step. Such contact damage may e.g., be due to diffusion or deactivation of dopants causing a high contact resistance. As mentioned, the method facilitates low-temperature gate stack formation. Thereby, the method also facilitates a high-quality transistor, e.g., a transistor with high-quality source/drain contacts. Further, the method facilitates a large design freedom for the transistor production process flow. For example, the gate stack may be formed before or after the source/drain contacts. When using high-temperature gate stack formation, it may be necessary to form the gate stack before the source/drain contacts.

It is further a realization that it may be hard to fine-tune EWF/Vt using a low-temperature gate stack formation process. It is a realization that, at least for some types of dipole-forming layers, already a single ALD cycle will result in a thickness that may provide a (too) large EWF/Vt shift. By etching the dipole-forming layer such that a residue less than one monolayer remains, a small EWF/Vt may be provided. It is a realization that in particular for p-type FETs, it is hard to achieve a small EWF/Vt shift in a low-temperature conventional gate stack formation process.

To illustrate advantages of the present method, consider the following. In pursuit of continuous scaling, advanced transistor architectures have been developed. Such architectures include the nanosheet (NS) gate-all-around (GAA), forksheet (FS), and complementary FET (CFET) devices. Such architectures are not compatible, or at least not optimally compatible, with traditional schemes to control Vt as discussed above.

To this end, further consider the formation of such advanced transistor architecture, especially the CFET device. CFET devices may, per known art, comprise the step of stacking a top NFET on a bottom PFET or vice versa thereby forming a CMOS. The step of stacking the top FET on the bottom FET may be performed in a variety of ways. However, for sake of brevity, said step will not be substantiated in detail. Instead, the general steps of forming the gate stack and the contacts of the respective FET device will be presented briefly in the following steps.

Completing the bottom FET may generally comprise the steps of:
forming source/drain regions;
replacing a dummy gate structure (sacrificial gate structure) in a high-temperature first RMG process;
forming a bottom contact to the source/drain regions.

Similarly, completing the top FET may generally comprise the steps of:
forming source/drain regions;
replacing a dummy gate structure (sacrificial gate structure) in a low-temperature second RMG process;
forming a top contact to the source/drain regions.

The steps as required to complete each of the bottom and top FET devices are similar. However, the second RMG process is performed under low-temperature (below 500 °C, more preferably below 430°C) conditions. This is particularly favourable since subjecting contacts to high-temperature processing steps is detrimental to the stability of the contacts. Hence, by ensuring that the second RMG process is performed under low-temperature conditions, the previously formed contacts of the bottom FET will remain robust.

To this end, the step of forming the residue is devoid of any processing steps that need to be performed under high-temperature conditions. Hence, the present method is suitable to be used in conjunction with low-temperature gate formation processes. In the context of the example above, the present method may be used in the low-temperature second RMG process and enables a low-temperature formation of a top FET gate stack with a fine tunable effective work function while avoiding degrading already formed bottom FET S/D contacts. Hence, the present method is particularly advantageous for application in more advanced transistor architectures where formation of a bottom FET and a top FET is formed in sequence.

In contrast, a traditional scheme to control Vt requiring a high-temperature annealing step would degrade already formed contacts. In the context of the example above, had a traditional scheme been used in conjunction with the second RMG process, the already formed contacts of the bottom FET would degrade. As such, the present method is compatible with a low temperature RMG process (or any other low-temperature gate formation step) and particularly with advanced transistor architectures such as the CFET. More particularly, the present method does not require the step of applying a (high-temperature) drive-in anneal.

The first aspect of the invention is also based on the insight that advanced transistor architectures comprising vertically arranged channels will conventionally have a vertical sheet pitch and a vertical sheet-sheet space. The vertical sheet pitch refers to the space between adjacent vertically arranged channels and including the thickness of one of the channels. The vertical sheet-sheet space refers to the space between adjacent vertically arranged channels (excluding the channels). In any case. vertical sheet pitch scaling is a requirement for reducing parasitic capacitance. Vertical sheet pitch scaling is also a driving force behind general device scaling. Application of traditional schemes to control Vt in advanced transistor architecture is associated with scaling challenges. This, since the pitch, especially the vertical sheet pitch, in advanced transistor architecture is generally small while application of traditional schemes requires that the pitch be large enough in order to enable the formation of an interface dipole region.

Accordingly, it is a realization that by etching the dipole-forming layer such that a thickness of the residue being less than one monolayer of the dipole-forming layer, vertical sheet pitch scaling is enabled. This will facilitate general device scaling. In this context, by the expressions "vertical sheet pitch scaling" or "general device scaling" it is herein meant that the present method enables the formation of a comparably thin gate stack compared to alternative prior art methods. Hence, the present method provides a scheme for controlling EWF/Vt in transistor structures having vertically arranged channels where the pitch, e.g., the vertical sheet pitch, is comparably small. In any case, the present method may be applied to any other semiconductor devices configured to comprise a gate stack and not only transistor architectures having a plurality of channels being vertically arranged. However, the present method is particularly advantageous for transistor structures where the channels are vertically arranged, and the vertical sheet pitch is comparably small.

It may in this context be noted that the dielectric interlayer may be intended to be a dielectric layer comprised in a semiconductor device which includes a conventional field effect transistor (FET) but also more advanced transistor architectures such as the FinFET, nanosheet (NS) gate-all-around (GAA), forksheet (FS), and complementary FET (CFET) devices.

It may in this context be further noted that promising n-type work function shifting metals and processes for controlling EWF/Vt of n-type FET devices are widely available. However, suitable work function shifting metals and processes for controlling EWF/Vt of p-type FET devices are not as widely available. Thus, the present method provides a scheme for controlling EWF/Vt of p-type FET devices. Nonetheless, it should be noted that the present method may be equally applied to n-type FET devices. In such case, the choice of work function shifting metal will differ. In other words, the choice of work function shifting metal ought to be adapted depending on which type (n-type or p-type) of FET device is to be controlled. In case the present method is applied to a p-type FET device, the work function shifting metal may comprise any one of aluminium (Al), titanium (Ti), germanium (Ge), and niobium (Nb). In case the present method is applied to an n-type FET device, the work function shifting metal may comprise any one of lanthanum (La), yttrium (Y), scandium (Sc), magnesium (Mg), gadolinium (Gd), dysprosium (Dy), erbium (Er), strontium (Sr), and barium (Ba).

By the term "monolayer" it is herein meant an atomically thin layer of material. In other words, the thickness of the layer may be as thin as a single atom. It is noted that compounds may form monolayers. Hence, the thickness of the layer may be as thin as a single unit compound. The monolayer is also intended to cover an entirety of the underlying layer and thereby form a continuous layer. However, the continuous layer may have naturally occurring vacancy defects and still be construed as a monolayer. It follows that the expression "less than a monolayer" is herein meant that the residue may form a layer having an area/surface density being less than that of a monolayer comprising the same atoms. In other words, the residue may form islands or patches of atoms, e.g., monolayer thick islands or patches.

The amount of the dipole-forming layer may be measured using e.g., Total Reflection X-ray Fluorescence (TXRF), Secondary Ion Mass Spectrometry (SIMS), Rutherford Backscattering Spectrometry (RBS), Elastic Recoil Detection (ERD), or X-ray Fluorescence (XRF). In the context of TXRF, if the residue of the dipole-forming layer gives a lower TXRF signal than a reference sample comprising one monolayer of the same type of dipole-forming layer, then said residue may be said to be less than one monolayer.

It is noted that a residue forming an atomically thin layer and having naturally occurring vacancy defects technically has an area/surface density being akin to that of a monolayer. However, this is not to be construed as being "residue being less than a monolayer". The residue layer may have intended openings, hence being "less than a monolayer". Such intended openings may be formed by sufficient etching of the dipole-forming layer, such that the residue forms islands of atoms.

By the term "thermal budget" it is herein meant the product of an annealing temperature and an annealing time.

By the term "drive-in anneal" it is herein meant a process involving heating the semiconductor structure to high temperatures to diffuse atoms into an adjacent layer (e.g. an underlying dielectric layer) for the purpose of forming an interface dipole region capable of shifting the EWF/Vt. The diffused atoms may hence form dipole-forming atoms intended to shift the EWF/Vt.

By the term "fine-tune" it is herein meant the act of shifting the EWF/Vt in comparably small steps. To illustrate, Al₂O₃ is a material suitable to be used for shifting the EWF/Vt of p-type FET devices. In order to shift the EWF/Vt, the material, Al₂O₃, may be deposited on the dielectric interlayer of the p-type FET device in conjunction with the gate formation processing step. This forms a layer of Al₂O₃ on top of the dielectric interlayer. In alternative schemes, this layer will often remain on the dielectric interlayer. Such a deposition may be performed by atomic layer deposition (ALD). However, even after merely a single cycle of ALD, the shift of the EWF/Vt is redundantly high. In this context, a redundantly high shift of the EWF may be in the range of 200 meV. In contrast to traditional schemes, the present method involves the step of etching the layer of Al₂O₃, hence actually reducing said layer to a thin residue of Al₂O₃. This provides for a small shift of the EWF being in the range of 40 - 80 meV, while also maintaining the equivalent oxide thickness (EOT).

It is a realization that the etch rate of the dipole-forming layer may be reduced at thicknesses below one monolayer. Thus, below one monolayer the amount of residue may decrease slowly. This further facilitates fine-tuning of EWF/Vt.

By the term "equivalent oxide thickness (EOT)" it is herein meant the thickness of silicon dioxide (SiO₂) film that provides the same electrical performance (e.g. capacitance) as that of a high-κ material being used.

By the term "pitch" is it herein meant the spacing between objects and including the thickness of one of the objects. In advanced transistor structures, the channels, usually being nanosheet-based may be vertically arranged with a predetermined pitch. Hence, in this context, vertical sheet pitch, denotes the vertical spacing between two adjacent channels and including the thickness of one of the channels. A vertical spacing is usually in the range of 5 - 15 nm.

In the context of the present disclosure, a layer being "provided on" another layer generally refers to that the layer is arranged "above" the another layer. Thereby, the terms "below"/"above" or "bottom"/"top" relate to layers of the material stack, in particular to the fabrication/growth direction of these layers. In any case, unless otherwise stated, the expression "provided on" means that the layer is in physical contact with the other layer. For instance, the layer may be (epitaxially) grown on the other layer. In the context of the gate stack being formed on the semiconductor substrate, it should still be noted that there may be arranged an intermediate layer between the gate stack and the substrate.

The gate stack may be a gate stack of a non-planar field effect transistor, FET.

A non-planar field effect transistor, FET, may include any one of the finFET, Gate-All-Around (GAA), nanosheet (NS), forksheet (FS), and complementary FET (CFET) devices. In such devices, it is preferred that the pitch is reduced for the purpose of device scaling. As noted above, the present method enables further device scaling.

The gate stack may be formed after forming a contact to the substrate. As explained above, the method is equally applicable to a channel of an intended FET. The contact may be a source/drain contact to said channel.

Formation of certain semiconductor structures may involve forming contacts to the substrate (e.g., contacts to S/D regions of the substrate) prior to forming a gate stack. For instance, formation of a CFET device may comprise stacking a top FET on a bottom FET. As discussed above, completing the top FET may comprise a gate formation processing step. However, at that stage, contacts to the bottom FET have already been formed. By forming the gate stack after forming a contact to the S/D regions/substrate, the risk of the already formed contacts being degraded is mitigated. This is advantageous for certain advanced transistor architectures where formation of a bottom FET and a top FET is formed in sequence.

The residue may comprise less oxygen than the oxygen of one hundredth of a monolayer of the dipole-forming layer.

The residue may comprise less of the work function shifting metal than half of a monolayer of the dipole-forming layer.

It is implied that the dipole-forming layer is etched to such an extent that there is little to barely any of the dipole-forming layer left on the dielectric interlayer. The resulting residue may not even comprise a sufficient amount of atoms to form a single uniform monolayer arranged on the dielectric interlayer. Hence, the residue may form islands or clusters of atoms on the dielectric interlayer. Each of the islands or clusters may be a monolayer (i.e., a sub-monolayer) in terms of thickness. In this sense, the residue may comprise a plurality of disconnected islands or clusters. Albeit the residue may not necessarily form a single uniform monolayer covering the entirety of the dielectric interlayer, the residue still enables fine-tuning of the EWF/Vt while also being compatible with advanced transistor structures where the pitch is comparably small.

The amount of oxygen can be measured by means of secondary ion mass spectrometry (SIMS), Rutherford Backscattering Spectrometry (RBS), or Elastic Recoil Detection (ERD).

The amount of work function shifting metal can be measured by means of SIMS, or RBS or ERD.

The work function shifting metal may comprise aluminium.

Aluminium is a work function shifting metal suitable to control the EWF/Vt of p-type FET devices. However, it is conceivable that other metals are suitable to control the EWF/Vt of p-type FET devices, such as any one of titanium, germanium, and niobium.

By the work function shifting metal comprising aluminium, a comparably small shift in EWF may be introduced. In this context, a small shift of the EWF may be in the range of 40 - 80 meV.

The gate dielectric may comprise a high-k dielectric layer.

The high-k dielectric layer may comprise hafnium oxide or zirconium oxide.

Hafnium oxide and zirconium oxide are high-k materials and may serve to reduce the gate leakage current. Each of these materials have a comparably low EOT. This enables an increased device performance. Hafnium oxide may be HfO2. Zirconium oxide may be ZrO2. Alternatively, the high-k dielectric layer may comprise hafnium silicate, zirconium silicate, aluminium oxide, titanium oxide, yttrium oxide, hafnium zirconium oxide, among others.

Forming the dipole-forming layer may be done by atomic layer deposition, ALD.

Thus, a high-quality dipole-forming layer may be formed.

An area density of the residue may range from 5×10¹³ to 3×10¹⁴ atoms/cm².

It is implied that the dipole-forming layer is etched to such an extent that there is little to barely any of the dipole-forming layer left on the dielectric interlayer. Accordingly, the area density of the residue may be lower than that of a monolayer covering the entirety of the dielectric interlayer. Hence, it is further implied that the residue need not form a continuous monolayer covering the entirety of the dielectric interlayer. By virtue of the area density of the residue, the residue enables fine-tuning of the EWF/Vt while being compatible with advanced transistor structures where the pitch is comparably small.

The act of etching the dipole-forming layer may be performed by wet etching.

Said act of wet etching may be performed using an ammonia hydrogen peroxide mixture, APM, or a hydrochloric acid hydrogen peroxide mixture, HPM.

The act of etching the dipole-forming layer may be performed at an etching temperature in a range of 30 - 80°C.

This temperature range ensures that the act of etching the dipole-forming layer does not degrade any components, particularly the contacts, of the semiconductor structure. As noted above, the stability of the contacts degrades with increased temperature. By way of example, the temperature range may be in a range of 40 - 70°C. By way of another example, the temperature range may be in a range of 50 - 60°C.

The act of etching the dipole-forming layer may be performed at an etching time being at least 20 s.

This etching time ensures that the dipole-forming layer is sufficiently etched, thereby forming a residue being less than one monolayer of the dipole-forming layer. By way of example, the etching time may be 20, 30, 40, 50, 60, 70, 80, 90, or 100 s. By way of another example, the etching time may be expressed as a time range. For instance, the etching time may be between 20 - 100 s.

The method may further comprise:
forming a masking layer on top of the dielectric interlayer, the masking layer being formed prior to forming the dipole-forming layer, the masking layer comprising
   open areas allowing contact between the dipole-forming layer and the dielectric interlayer; and
   masked areas preventing contact between the dipole-forming layer and the dielectric interlayer, the method further comprising
removing the masking layer after or during etching the dipole-forming layer.

Subsequent to forming the masking layer, the dipole-forming layer may be formed on top of the masking layer and parallel therewith. The dipole-forming layer may be in direct contact with the masking layer, and more specifically the masked areas. Through the open areas of the masking layer, the dipole-forming layer may be in direct contact with the dielectric interlayer. By virtue of the open areas of the masking layer, the residue will remain on those portions of the dielectric interlayer where the dipole-forming layer is in direct contact with the dielectric interlayer. Hence, the residue may form intended islands. It is also implied that removal of the masking layer will also remove portions of the dipole-forming layer. Thus, the residue will be less than had there not been a masking layer between the dielectric interlayer and the dipole-forming layer. This configuration enables a more precise and intricate fine-tuning of the EWF/Vt. In other words, this configuration enables the act of shifting the EWF/Vt in even smaller steps.

By the expression "the residue will be less" it is herein meant that the residue will comprise comparably less material.

### BRIEF DESCRIPTION OF THE DRAWINGS

The above, as well as additional objects, features and advantages of the present inventive concept, will be better understood through the following illustrative and non-limiting detailed description, with reference to the appended drawings. In the drawings like reference numerals will be used for like elements unless stated otherwise.
Figs. 1a-d illustrate the gate stack formation steps of a method applied to a semiconductor device in a schematically depicted cross-sectional view.
Figs. 2a-b illustrate the gate stack formation steps of method applied to a semiconductor device in a schematically depicted cross-sectional view.
Fig. 3 is a flow chart of a method for forming a gate stack applied to a method for forming a complementary FET (CFET) device.

### DETAILED DESCRIPTION

In the following, the formation of a gate stack 100 will be exemplified in the context of a gate stack for a field-effect transistor (FET) device. Such a device may be a conventional field effect transistor (FET) but also a comparably more advanced FET device such as a nanosheet (NS) gate-all-around (GAA), forksheet (FS), or complementary FET (CFET) device. In any case, the gate stack 100 may be a gate stack of both planar and non-planar FET devices. It should be noted that the formation of the gate stack 100 need not be confined to merely transistor devices, but may be applied to other semiconductor devices.

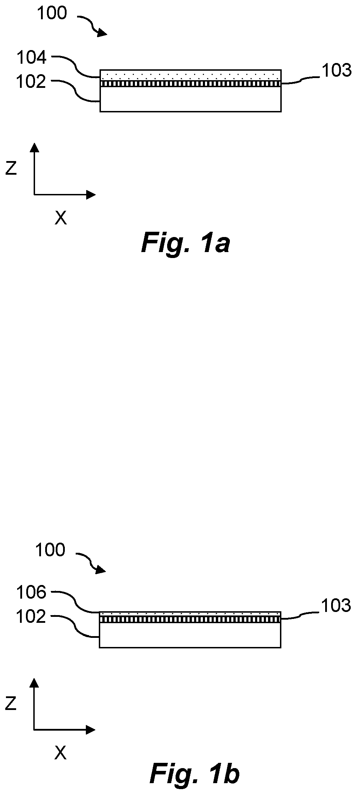

Referring now to Fig. 1a, an initial formation of the gate stack 100 on a substrate 102 is illustrated.

Whenever there is a reference to a gate stack 100 being formed on a semiconductor substrate 102, it should be noted that there may be arranged an intermediate layer between the gate stack 100 and the substrate 102. Such an intermediate layer may be a channel layer. Hence, the gate stack 100 may be formed on a channel of a semiconductor device e.g., the channel between the source and drain (S/D) regions of the semiconductor device.

In the case that a gate stack 100 is formed on (or alternatively expressed, in physical contact with) a channel, the following may be performed. Prior to forming the gate stack 100, the channel layer may be released. For example, the channel layer may be part of a layer stack comprising a sacrificial layer below the channel layer and a sacrificial layer above the channel layer. The channel layer may be released by removing the sacrificial layers. The gate stack 100 may be formed around the channel layer, e.g. as a gate-all-around. Alternatively, the gate stack 100 may be formed at three sides of the channel layer, e.g. as a tri-gate (e.g. for a forksheet FET). It is conceivable that the channel may be formed on top of or above the substate 102. This is conventionally the case with non-planar FET devices such as NSFET devices. The channel may alternatively be formed as part of the substrate 102. In other words, the substrate 102 may comprise the channel. This is conventionally the case with planar FET devices such as MOSFET devices.

In any case, the substrate 102 may be a substrate layer for a FET, e.g. a substrate for a NSFET, a substrate for a CFET, or a substrate for a forksheet FET.

Alternatively, the substrate 102 may be a conventional semiconductor substrate suitable for e.g. complementary metal-oxide semiconductor (CMOS). The substrate 102 may comprise silicon (Si), germanium (Ge) substrate or silicon-germanium (SiGe).

Whenever there is a reference to a layer being formed, this is preferably performed using conventional semiconductor fabrication technology, such as atomic layer deposition (ALD), thin-film deposition, metalorganic chemical vapour deposition (MOCVD), physical vapor deposition (PVD) or the like. The layers of the gate stack 100 may advantageously be deposited by conformal deposition, e.g. ALD. In the case where the substrate 102 is a channel layer, the layers of the layer stack comprising said channel layer may be epitaxially grown.

In the figures, directions X and Z indicate a horizontal and a vertical direction, respectively. Direction Z indicates a vertical or bottom-up direction (normal to the substrate 102). The figures illustrate a respective cross-section of a center view parallel to the XZ-plane.

The method further comprises depositing a dielectric interlayer 103 on the substrate 102. The dielectric interlayer 103 forms a layer arranged on a surface of the substrate 102 and parallel therewith. The dielectric interlayer 103 is configured to be arranged in contact with the substrate 102. It is, however, conceivable that there may be arranged an intermediate layer between the dielectric interlayer 103 and the substrate 102.

The dielectric interlayer 103 is a layer of dielectric material. The dielectric interlayer 103 may comprise silicon oxide (SiO), or silicon dioxide (SiO₂), and/or silicon oxynitride (SiON).

The method further comprises forming a dipole-forming layer 104 on top of the dielectric interlayer 103. The dipole-forming layer 104 may be formed by means of atomic layer deposition, ALD. Thus, the dielectric interlayer 103 is arranged between the dipole-forming layer 104 and the semiconductor substrate 102. The dipole-forming layer 104 is preferably arranged on the dielectric interlayer 103 such that a physical interface therebetween is formed. However, it is also conceivable that there may be arranged one or more additional intermediate layers between the dielectric interlayer 103 and the dipole-forming layer 104. In such a case, the dipole-forming layer 104 may form an interface with an upper most intermediate layer.

The dipole-forming layer 104 comprises a work function shifting metal. The work function shifting metal is configured to control the band-edge effective work function (EWF)/the threshold voltage (Vt). The choice of work function shifting metal ought to be adapted depending on which type (n-type or p-type) of FET device is to be controlled. In case the present method is applied to a p-type FET device, the work function shifting metal may comprise any one of aluminium (Al), titanium (Ti), germanium (Ge), and niobium (Nb). In case the present method is applied to an n-type FET device, the work function shifting metal may comprise any one of lanthanum (La), yttrium (Y), scandium (Sc), magnesium (Mg), gadolinium (Gd), dysprosium (Dy), erbium (Er), strontium (Sr), and barium (Ba).

The work function shifting metal may form part of an oxide. For instance, the dipole-forming layer 104 may comprise aluminium oxide, Al₂O₃. Accordingly, the work function shifting metal is aluminium.

The dipole-forming layer 104 and the dielectric interlayer 103 may comprise different materials such that a distinct interface is formed therebetween.

Referring now to Fig. 1b, the method further comprises etching the dipole-forming layer 104 such that a residue 106 of the dipole-forming layer 104 remains on the dielectric interlayer 103. It should be noted that the residue 106 has been schematically depicted. As previously mentioned, the residue may form islands or patches of atoms, e.g., monolayer thick islands or patches.

The residue 106 preferably forms a layer being less than a monolayer in order to enable fine adjustments of the EWF/Vt. It should be noted that even should the residue 106 form a monolayer, adjustments of the EWF/Vt are still possible. However, comparably finer adjustments of the EWF/Vt are enabled by the residue being less than a monolayer.

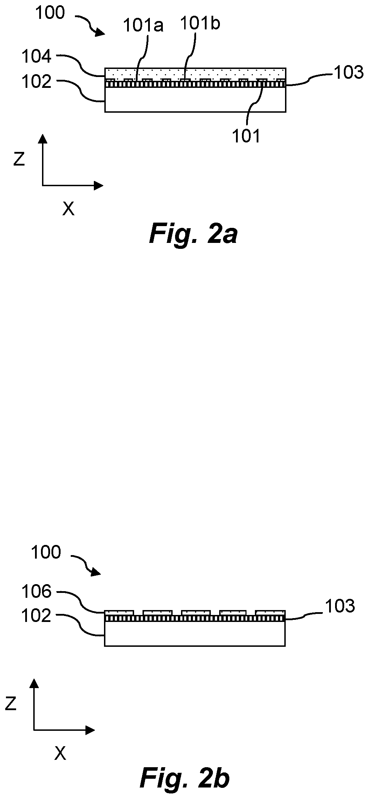

Fig. 2b specifically illustrates the case where the dipole-forming layer 104 is etched to such an extent that the resulting residue 106 forms a layer being less than a monolayer. It is implied that the residue 106 does not comprise a sufficient amount of atoms to form a monolayer. By virtue of the etching, intended openings have been formed. The residue 106 may form islands or clusters of atoms on the dielectric interlayer 103 and wherein each of the islands may be a monolayer (i.e., sub-monolayers). In this sense, the residue 106 may comprise a plurality of islands and wherein each island may be atomically thin. Albeit the residue 106 does not form a single monolayer covering the entirety of the dielectric interlayer 103, the residue still enables fine-tuning of the EWF/Vt while also being compatible with advanced transistor structures where the pitch is comparably small.

Referring back to Fig. 1b, an interface dipole region may be formed between the residue 106 and the underlying dielectric interlayer 103. The residue 106, or more particularly, the interface dipole region, may enable fine adjustments of the EWF/Vt.

As noted above, the dipole-forming layer 104 may comprise an oxide. Accordingly, the dipole-forming layer 104 may be etched to such an extent that the residue 106 comprises less oxygen than the oxygen of one hundredth of a monolayer of the dipole-forming layer 104. The amount of oxygen can be measured by means of secondary ion mass spectrometry (SIMS).

Further, the residue 106 may comprise less of the work function shifting metal than half of a monolayer of the dipole-forming layer 104. The amount of work function shifting metal can be measured by means of SIMS.

Etching of the dipole-forming layer 104 may be performed by means of wet chemistry. The etching may be performed using an ammonia hydrogen peroxide mixture (APM). Subsequent to etching of the dipole-forming layer 104, the resulting layer stack may be subject to a cleaning process. That cleaning process may be performed using a hydrochloric acid hydrogen peroxide mixture (HPM).

The act of etching the dipole-forming layer 104 may be performed at an etching temperature in a range of 30 - 80°C. By way of example, the temperature range may be in a range of 40 - 70°C. By way of another example, the temperature range may be in a range of 50 - 60°C.

The act of etching the dipole-forming layer 104 may be performed at an etching time being at least 20 s. By way of example, the etching time may be 20, 30, 40, 50 ,60 , 70, 80, 90 , or 100 s. By way of another example, the etching time may be expressed as a time range. For instance, the etching time may be between 20 - 100 s.

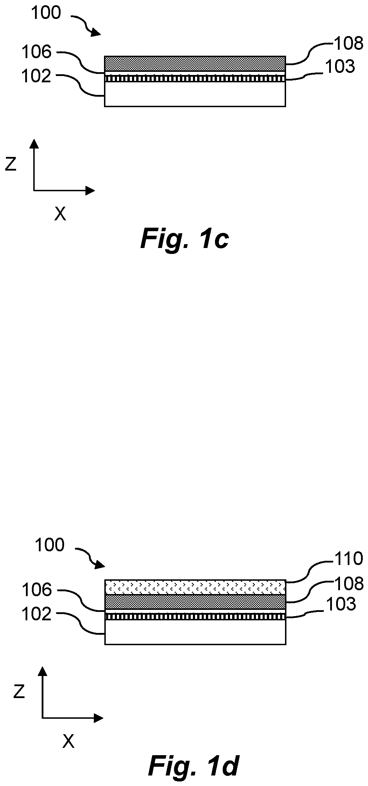

Referring now to Fig. 1c, the method further comprises depositing a gate dielectric 108. The gate dielectric 108 may be a layer arranged on the residue 106 and parallel therewith.

The gate dielectric 108 may comprise a high-k dielectric layer. The high-k dielectric layer may comprise hafnium oxide or zirconium oxide.

A dipole capping layer may be formed on the residue 106 prior to depositing the gate dielectric 108.

Referring now to Fig. 1d, the method further comprises depositing a metal gate (electrode) 110. Whenever there is a reference to a metal gate, this may be equally applied to a metal gate electrode. The metal gate 110 may be a layer arranged on the gate dielectric 108 and parallel therewith. The metal gate 110 may comprise a work function metal. The work function metal may be intended to introduce an initial shift of EWF/Vt.

The method may further comprise forming an (non-illustrated) electrical contact element on top of the metal gate 110. However, this does not imply that the electrical contact element necessarily needs to be in direct physical contact with the metal gate 110. On the contrary, one or more intermediate layers may be interposed between the metal gate 110 and the electrical contact element such that electrical contact is provided via at least one intermediate layer. Such an intermediate layer may for instance be a capping layer. The electrical contact element may form a gate electrode. It is conceivable that an intermediate layer, e.g. a capping layer, may form part of the electrical contact element. As such, the capping layer and the electrical contact element may together form a gate electrode to the gate stack 100.

The electrical contact element may be formed of a metal with high electrical conductivity, such as copper, aluminium, cobalt, ruthenium, or silver. Alternatively, the electrical contact element may be formed of a semiconductor material comprising, for instance, amorphous silicon (a-Si) or polycrystalline silicon (poly-Si).

Fig. 2a illustrates the case where a masking layer 101 is formed on the dielectric interlayer 103 prior to forming the dipole-forming layer 104.

The masking layer 101 may be formed in direct contact with the dielectric interlayer 103 and parallel therewith. The masking layer 101 comprises open areas 101a allowing contact between the dipole-forming layer 104 and the dielectric interlayer 103.The masking layer 101 may also comprise masked areas 101b preventing contact between the dipole-forming layer 104 and the dielectric interlayer 103.

Through the open areas 101a of the masking layer 101, the dipole-forming layer 104 may be in direct contact with the dielectric interlayer 103. The gate stack 100 may be subject to an anneal prior to the step of etching the dipole-forming layer 104. The anneal may be performed at a temperature being in the range of 300 - 500°C. By way of example, the temperature may be 430°C. The anneal may be performed by means of inert gas such as hydrogen, H₂, nitrogen, N₂, helium, He, and argon, Ar.

In the following, the formation of a gate stack 100 will be exemplified in the context of a complementary FET (CFET) device. This section further serves to highlight advantages of the present method compared to traditional methods.

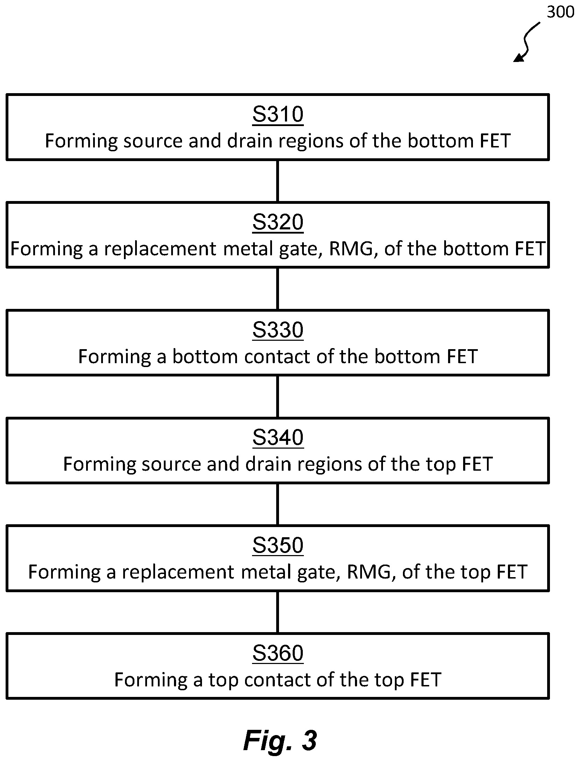

Accordingly, Fig. 3 shows a flow chart 300 for an overall example process flow for forming a CFET device. The general architecture of a CFET device involves stacking a top FET on a bottom FET thereby forming a CMOS.

The step of stacking the top FET on the bottom FET may be performed in a variety of ways. However, for sake of brevity, said step will not be substantiated in detail. In any case, the step of stacking the top FET on the bottom FET is known in the art. Instead, the general steps of forming the gate stack 100 and the contacts of the respective FET device of the CFET device will be presented the following steps:

In step S310, source and drain (S/D) regions of the bottom FET are formed. Forming S/D regions may comprise a patterning process involving e.g. etching.

In step S320, a dummy gate structure (sacrificial gate structure) of the bottom FET is replaced in accordance with a high-temperature first replacement metal gate (RMG) process. In this context it may be noted that the dummy gate structure is intended to be replaced by a (second) functional gate structure. The functional gate structure may be a replacement metal gate structure.

The term "functional gate structure" or "final gate structure" here refers to a gate structure providing the function of a gate in the finished devices.

In step S330, a bottom contact is formed. The bottom contact may be intended to be a contact to the S/D regions. The bottom contact may comprise one contact intended for the source region, and one contact intended for the drain region.

In step S340, source and drain (S/D) regions of the top FET are formed. Forming S/D regions of the top FET may comprise a patterning process involving e.g. etching.

In step S350, a dummy gate structure (sacrificial gate structure) of the top FET is replaced in accordance with a low-temperature second replacement metal gate (RMG) process. In this context it may be noted that the dummy gate structure is intended to be replaced by a (second) functional gate structure. The functional gate structure may be a replacement metal gate structure.

In step S360, a top contact is formed. The top contact may be intended to be a contact to the S/D regions. The top contact may comprise one contact intended for the source region, and one contact intended for the drain region.

The second RMG process is specifically a low-temperature gate formation step. This is particularly favourably since subjecting contacts to high-temperature processing steps is detrimental to the stability of the contacts. To this end, the present method does not comprise any processing steps that need be performed under high-temperature conditions. Hence, the present method is suitable to be used in conjunction with low-temperature gate formation processes. In the context of the example above, the present method may be used in step S350, i.e. in the low-temperature second RMG process and enables a low-temperature formation of a top FET gate stack with a fine tunable effective work function while avoiding degrading the already formed bottom FET S/D contacts. It should be noted that the present method does not require the step of applying a (high-temperature) drive-in anneal. Hence, the present method is particularly advantageous for application in more advanced transistor architectures where formation of a bottom FET and a top FET is formed in sequence.

In contrast, a traditional scheme to control Vt requiring a high-temperature annealing step would degrade already formed contacts. In the context of the example above, had a traditional scheme been used in step S350, i.e., in conjunction with the second RMG process, the already formed contacts of the bottom FET as formed in step S330 would degrade.

The layers of the semiconductor device as illustrated in the figures may be formed of the materials as discussed in various levels above. Preferably, the dielectric interlayer 103 is formed of SiO₂, and the dipole-forming layer 104 of Al₂O₃. The work function shifting metal is therefore preferably of Al atoms and forming part of a p-type FET device.

In the above the inventive concept has mainly been described with reference to a limited number of examples. However, as is readily appreciated by a person skilled in the art, other examples than the ones disclosed above are equally possible within the scope of the inventive concept, as defined by the appended claims.

## Claims

1. A method for forming a gate stack (100) on a semiconductor substrate (102), the method comprising:
forming a dielectric interlayer (103) on the semiconductor substrate (102),
forming a dipole-forming layer (104) comprising a work function shifting metal and oxygen on top of the dielectric interlayer (103);
etching the dipole-forming layer (104) such that a residue (106) of the dipole-forming layer (104) remains on the dielectric interlayer (103), the residue (106) being less than one monolayer of the dipole-forming layer (104), wherein a temperature is kept below 430 °C between said acts of forming the dipole-forming layer (104) and etching the dipole-forming layer (104);
depositing a gate dielectric (108); and
depositing a metal gate (110) on the gate dielectric (108).

2. The method according to claim 1, wherein the gate stack (100) is a gate stack (100) of a non-planar field effect transistor, FET.

3. The method according to claim 1 or 2, wherein the gate stack (100) is formed after forming a contact to the substrate (102).

4. The method according to any one of the preceding claims, wherein the residue (106) comprises less oxygen than the oxygen of one hundredth of a monolayer of the dipole-forming layer (104).

5. The method according to any one of the preceding claims, wherein the residue (106) comprises less of the work function shifting metal than half of a monolayer of the dipole-forming layer (104).

6. The method according to any one of the preceding claims, wherein the work function shifting metal comprises aluminium.

7. The method according to any one of the preceding claims, wherein the gate dielectric (108) comprises a high-k dielectric layer.

8. The method according to claim 7, wherein the high-k dielectric layer comprises hafnium oxide or zirconium oxide.

9. The method according to any one of the preceding claims, wherein forming the dipole-forming layer (104) is done by atomic layer deposition, ALD.

10. The method according to any one of the preceding claims, wherein an area density of the residue (106) ranges from 5×10¹³ to 3×10¹⁴ atoms/cm².

11. The method according to any one of the preceding claims, wherein the act of etching the dipole-forming layer (104) is performed by wet etching.

12. The method according to claim 11, wherein said act of wet etching is performed using an ammonia hydrogen peroxide mixture, APM, or a hydrochloric acid hydrogen peroxide mixture, HPM.

13. The method according to claim 12, wherein the act of etching the dipole-forming layer (104) is performed at an etching temperature in a range of 30 - 80°C.

14. The method according to claim 12 or 13, wherein the act of etching the dipole-forming layer (104) is performed at an etching time being at least 20 s.

15. The method according to any one of the preceding claims, further comprising:
forming a masking layer (101) on top of the dielectric interlayer (103), the masking layer (101) being formed prior to forming the dipole-forming layer (104), the masking layer (101) comprising
open areas (101a) allowing contact between the dipole-forming layer (104) and the dielectric interlayer (103); and
masked areas (101b) preventing contact between the dipole-forming layer (104) and the dielectric interlayer (103), the method further comprising
removing the masking layer (101) after or during etching the dipole-forming layer (104).
